# EUROPÄISCHE PATENTANMELDUNG

(11) **EP 2 239 768 A1**
(43) Veröffentlichungstag der Anmeldung: **13.10.2010**
(21) Anmeldenummer: 10001492.7
(22) Anmeldetag: 13.02.2010
(51) Int. Cl.: H01L 21/60, H01L 25/07, H01R 13/24

(54) **Leistungshalbleitermodul mit einer Verbindungseinrichtung und mit als Kontaktfeder ausgebildeten internen Hilfanschlusselementen**

(30) Priorität: 11.04.2009 DE 102009017733
(71) Anmelder: SEMIKRON Elektronik GmbH & Co. KG, 90431 Nürnberg (DE)
(72) Erfinder: Knebel, Markus, 90587 Tuchenbach (DE); Beckedahl, Peter, 90522 Oberasbach (DE)

(57) **Zusammenfassung**

Die Erfindung beschreibt ein Leistungshalbleitermodul mit mindestens einem Leistungshalbleiterbauelement, mit einer dieses Leistungshalbleiterbauelement kontaktierenden Verbindungseinrichtung aus einem Schichtverbund aus mindestens einer ersten elektrisch leitenden dem Leistungshalbleiterbauelement zugewandten, mindestens eine erste Leiterbahn ausbildenden Schicht und einer im Schichtverbund folgenden isolierenden Schicht und einer im Schichtverbund weiter folgenden zweiten dem Leistungshalbleiterbauelement abgewandten, mindestens eine zweite Leiterbahn ausbildenden, Schicht. Weiterhin weist das Leistungshalbleitermodul mindesten ein internes Anschlusselement auf, wobei dieses interne Anschlusselement als Kontaktfeder mit einem ersten und einem zweiten Kontaktabschnitt und einem federnden Abschnitt ausgebildet ist. Hierbei weist der erste Kontaktabschnitt eine gemeinsame Kontaktfläche mit einer ersten oder einer zweiten Leiterbahn der Verbindungseinrichtung aufweist.

## Beschreibung

### Beschreibung

Die Erfindung beschreibt eine Leistungshalbleitermodul mit einer internen Verbindungseinrichtung, die ausgebildet ist als ein Schichtverbund aus einer Mehrzahl elektrisch leitender Schichten, die ihrerseits eine Mehrzahl von Leiterbahnen ausbilden können und zwischen diesen Schichten angeordneten isolierenden Schichten. Diese Verbindungseinrichtung dient der elektrischen Verbindung von Leistungshalbleiterbauelementen untereinander oder zu weiteren Leiterbahnen eines Substrats.

Einen Ausgangspunkt der Erfindung bilden Leistungshalbleitermodule, wie sie beispielhaft aus der DE 103 55 925 A1 bekannt sind. Diese offenbart grundsätzlich eine Verbindungseinrichtung der oben genannten Art. Die Leistungshalbleiterbauelemente sind hier mit der ersten leitenden Schicht mittels Ultraschallschweißen dauerhaft sicher elektrisch verbunden. Die modulinterne schaltungsgerechte Verbindung der Leistungshalbleiterbauelemente, die sowohl interne Last- als auch Steueranschlüsse beinhaltet ist hier offen gelegt. Hierzu weist die Verbindungseinrichtung Durchkontaktierungen zwischen elektrisch leitenden Schichten durch isolierende Schichten hindurch auf. Auf diese Weise werden Leiterbahnen einer Schicht mit Leiterbahnen einer andern Schicht elektrisch verbunden.

Externe Verbindungseinrichtung von Leistungshalbleitermodul der genannten Art offenbart beispielhaft die DE 10 2006 027 482 A1. Hier werden einerseits Schraub- und andererseits federbelastete Steckkontaktverbindungen offenbart.

Demgegenüber offenbart die DE 10 2006 013 078 ein Leistungshalbleitermodul mit einer oben genannte Verbindungseinrichtung auf, bei der die Durchkontaktierungen zwischen zwei elektrisch leitenden Schichten mittels Dünndrahtbonden ausgebildet sind. Da die Verbindungseinrichtung der genannten Art auch zum Ersatz von Bondverbindungen innerhalb eines Leistungshalbleitermodul dienen und durch ihren Einsatz die Dauerhaltbarkeit der internen Verbindungen verbessert werden soll, kann hier der Einsatz der Dünndrahtbondverbindung zur Ausbildung einer Durchkontaktierung nicht vollständig befriedigen.

Der Erfindung liegt daher die Aufgabe zugrunde ein Leistungshalbleitermodul mit einer Verbindungseinrichtung derart weiter zu bilden, dass die Anzahl von Drahtbondverbindungen verringert wird.

Die Aufgabe wird erfindungsgemäß gelöst, durch die Maßnahmen des Anspruchs 1. Bevorzugte Ausführungsformen sind in den abhängigen Ansprüchen beschrieben.

Der erfinderische Gedanke geht aus von Leistungshalbleitermodul der eingangs genannten Art mit mindestens einem Leistungshalbleiterbauelement und mit einer Verbindungseinrichtung zur schaltungsgerechten modulinternen Verbindung des mindestens einen Leistungshalbleiterbauelements mit einem weiteren Leistungshalbleiterbauelement oder mit einer Leiterbahn eines Substrats. Derartige Leistungshalbleitermodule sind vorzugsweise mittels eines Substrats auf einer Kühleinrichtung anordenbar. Weiterhin weist ein derartiges Leistungshalbleitermodul bevorzugt ein isolierendes, das Substrat mit dem mindestens einen Leistungshalbleiterbauelement und die Verbindungseinrichtung umschließendes Gehäuse auf.

Die Verbindungseinrichtung besteht aus einem Schichtverbund aus mindestens zwei elektrisch leitenden Schichten und einer dazwischen angeordnet isolierenden Schicht. Es kann auch bevorzugt sein weitere Schichtfolgen aus isolierenden und leitenden Schichten der Verbindungseinrichtung vorzusehen. Ohne Beschränkung der Allgemeinheit wird im Folgenden aus Gründen der Übersichtlichkeit nur noch auf die einfachste Ausgestaltung der Verbindungseinrichtung mit zwei elektrisch leitenden und einer isolierend Schicht Bezug genommen.

Die jeweiligen leitenden Schichten können in sich strukturiert sein und hierdurch eine Mehrzahl voneinander isolierter ersten Leiterbahnen ausbilden. Mindestens eine erste Leiterbahn der ersten leitenden Schicht ist mit einer Kontaktfläche eines Leistungshalbleiterbauelements elektrisch leitend verbunden. Hierbei hat sich eine stoffschlüssige Verbindung oder auch ein Druckkontaktverbindung nach dem Stand der Technik als besonders vorteilhaft erwiesen. In der Schichtfolge folgt auf dies erste dem Leistungshalbleiterbauelement zugewandte leitende Schicht eine isolierende und anschließend wieder ein dem Leistungshalbleiterbauelement abgewandte leitende Schicht der Verbindungseinrichtung.

Erfindungsgemäß weist das Leistungshalbleiterbauelement mindestens ein internes Anschlusselement auf, wobei dieses interne Anschlusselement als Kontaktfeder mit einem ersten und einem zweiten Kontaktabschnitt und einem federnden Abschnitt ausgebildet ist. Der erste Kontaktabschnitt dieser Kontaktfeder weist eine gemeinsame Kontaktfläche mit einer ersten oder einer zweiten Leiterbahn der Verbindungseinrichtung auf.

Hierbei ist es bevorzugt, wenn die Kontaktfläche mit einer ersten oder zweiten Leiterbahn in einer Ausnehmung der Verbindungseinrichtung angeordnet ist. Hierdurch wird die Kontaktsicherheit zwischen der Leiterbahn und der Kontaktfeder erhöht, auch unter mechanischen oder thermischen Einflüssen, die eine laterale Bewegung der gesamten Kontaktfeder oder der ersten Kontakteinrichtung der Kontaktfeder bewirken könnten. Hierdurch wird auch eine mögliche Halterung und Führung der Kontaktfeder im Gehäuse vereinfacht, da diese geringe Anforderungen an die Positionierung der Kontaktfeder bzw. deren ersten Kontaktabschnitt erfüllen muss.

In einer ersten bevorzugten Ausgestaltung wird diese Ausnehmung gebildet durch eine Aussparung der zweiten Leiterbahn und der isolierenden Schicht. Es entsteht so eine Öffnung der Verbindungseinrichtung die bis zur ersten Leiterbahn hindurch reicht, wodurch die Kontaktfläche somit auf dieser ersten Leiterbahn angeordnet ist und die Kontaktfeder somit eine elektrisch leitende Verbindung zu dieser ersten Leiterbahn herstellt.

In einer zweiten bevorzugten Ausgestaltung wird diese Ausnehmung gebildet durch eine Vertiefung der zweiten Leiterbahn, die diese Leiterbahn nicht vollständig freispart, wodurch die Kontaktfläche auf der zweiten Leiterbahn angeordnet ist und die Kontaktfeder somit eine elektrisch leitende Verbindung zu dieser zweiten Leiterbahn herstellt.

Es ist weiterhin besonders vorteilhaft, wenn die zweite Kontakteinrichtung der Kontaktfeder aus dem Gehäuse des Leistungshalbleitermoduls herausragt. Hierdurch ist das Leistungshalbleitermodul und damit die Verbindungseinrichtung direkt mit externen Anschlusselementen verbindbar.

Die erfinderische Lösung wird an Hand der Ausführungsbeispiele der Fig. 1 bis 4 weiter erläutert.

Fig. 1 zeigt ein Leistungshalbleitermodul nach dem Stand der Technik im Schnitt.

Fig. 2 zeigt Details der Verbindungseinrichtung eines Leistungshalbleitermoduls nach dem Stand der Technik.

Fig. 3 zeigt Details der Verbindungseinrichtung eines erfindungsgemäßen Leistungshalbleitermoduls.

Fig. 4 zeigt ein erfindungsgemäßes Leistungshalbleitermodul im Schnitt

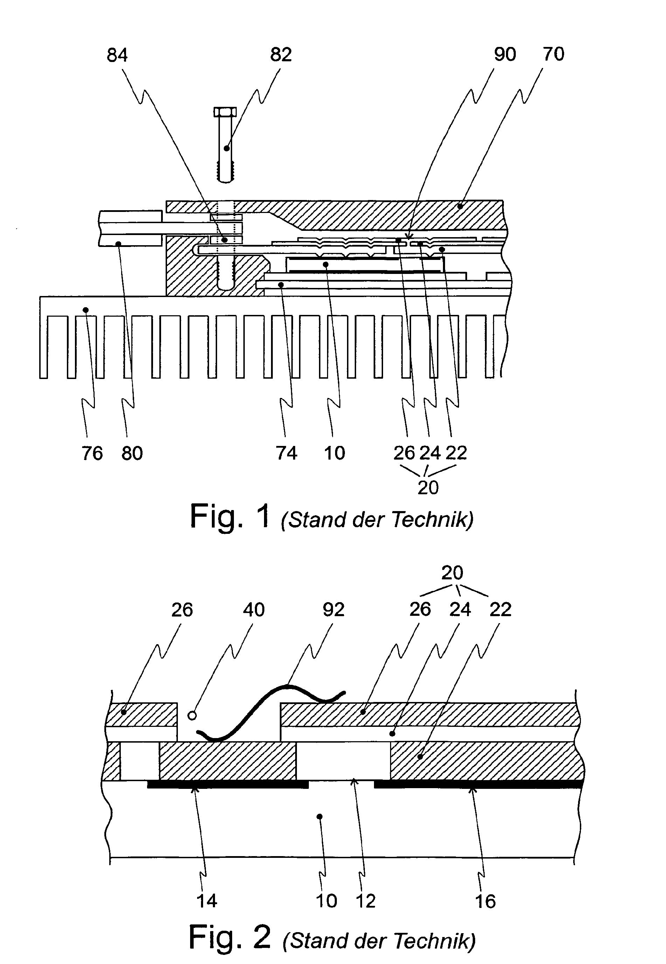

Fig. 1 zeigt ein Leistungshalbleitermodul nach dem Stand der Technik im Schnitt. Dargestellt ist ein Leistungshalbleitermodul angeordnet auf einer Kühleinrichtung (76), wobei das Leistungshalbleitermodul ein Substrat (74) mit einem Leistungshalbleiterbauelement (10) und einer Verbindungseinrichtung (20) aufweist. Diese Teile (10, 20, 74) des Leistungshalbleitermodul sind durch ein Gehäuse (70) umschlossen und bedeckt. Den unteren Abschluss des Leistungshalbleitermodul bildet hier das Substrat (74).

Die Verbindungseinrichtung (20) wird gebildet durch ein Schichtfolge aus einer ersten, dem Leistungshalbleiterbauelement (10) zugewandten elektrisch leitenden Schicht (22), ein hieran in der Schichtfolge anschließende isolierende Schicht (24) und eine zweite leitende Schicht (26). Es ist bevorzugt, wenn die Schichtdicken der elektrisch leitenden Schichten (22, 26) zwischen 10µm und 500µm betragen und wenn die Schichtdicke der isolierenden Schicht (24) zwischen 2µm und 100µm beträgt.

Die elektrisch leitenden Schichten (22, 26) bilden gemäß dem Stand der Technik die modulinterne schaltungsgerechte Verbindung von Leistungshalbleiterbauelementen (10) und dem Substrat (74) und ersetzt hiermit die vielfältig bekannten Drahtbondverbindungen. Hierbei ist es allerdings auch notwendig Durchkontaktierung (90) zur Verbindung erster Leiterbahnen (22) der ersten elektrisch leitenden Schicht mit zweiten Leiterbahnen (26) der zweiten elektrisch leitenden Schicht vorzusehen. Diese sind als elektrisch leitfähig verfüllte Ausnehmungen der isolierenden Schicht ausgebildet.

Weiterhin dient die Verbindungseinrichtung (20) hier der externen Kontaktierung in Form einer Schraubverbindung (82, 84) mit externen Anschlusselementen (80). Diese Art der externen Kontaktierung ist besonders geeignet für die Lastanschlüsse. Externe Kontaktierungen von Hilfsanschlüssen, wie Steueranschlüsse, Hilfsemitteranschlüsse oder Sensoranschlüsse sind auch als Steck- oder Lötverbindungen bekannt.

Fig. 2 zeigt Details der Verbindungseinrichtung eines Leistungshalbleitermoduls (10) mit einer Steuer- (14) und einer Emitteranschlussbereich (16) nach dem Stand der Technik. Dargestellt ist hier ein Alternative zur oben, vgl. Fig. 1, genannten Durchkontaktierung (90). In dieser bekannten Ausgestaltung bildet eine zum Teil in einer Ausnehmung (40) der Verbindungseinrichtung (20) angeordnete Dünndrahtbondverbindung (92) die elektrisch leitende Verbindung zwischen einer ersten Leiterbahn (22) der ersten elektrisch leitenden Schicht der Verbindungseinrichtung mit einer zweiten Leiterbahn (26) der zweiten elektrisch leitenden Schicht.

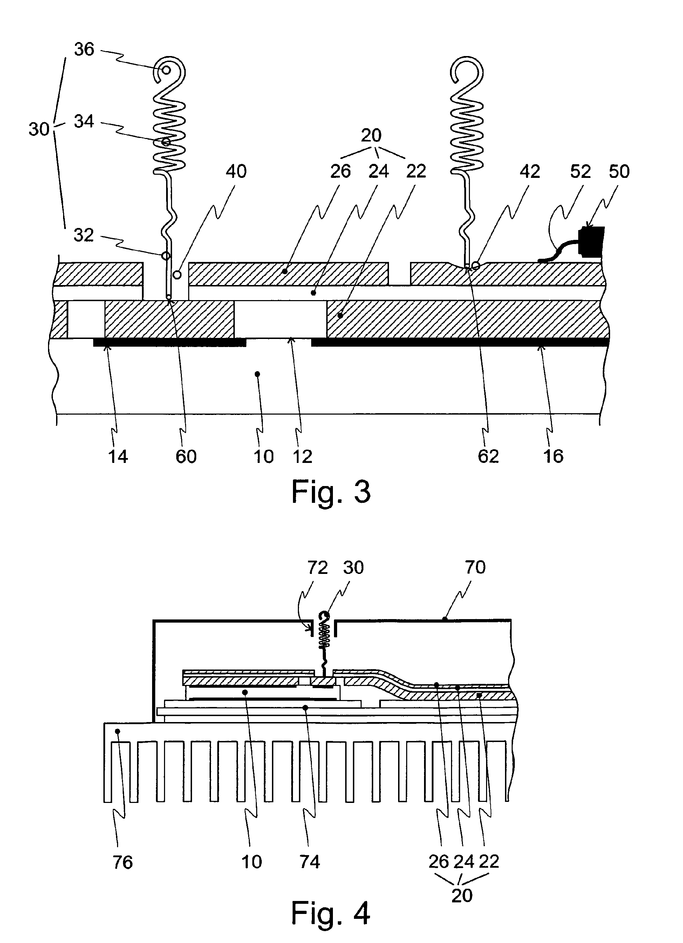

Fig. 3 zeigt Details der Verbindungseinrichtung (20), eines Leistungshalbleiterbauelements (10) und eines Sensors (50) eines erfindungsgemäßen Leistungshalbleitermoduls. Das Leistungshalbleiterbauelement (10), hier ein Leistungstransistor weist an seiner ersten Hauptfläche (12) zwei Kontaktbereiche, einen Steuer- (14) und einen Emitteranschlussbereich (16) auf. Diese beiden Kontaktbereiche (14, 16) sind mit zugeordneten und selbstverständlich elektrisch voneinander isolierten ersten Leiterbahnen (22) der ersten Schicht der Verbindungseinrichtung (20) verbunden. Es ist besonders bevorzugt, wenn diese beiden Verbindungen als stoffschlüssige, vorzugsweise durch einen Sinterprozess hergestellte, Verbindungen ausgebildet sind.

Die Verbindungseinrichtung (20) weist hier drei voneinander elektrisch isolierte erste Leiterbahnen (22), gebildet durch Strukturierung der ersten elektrisch leitenden Schicht, auf. Diese erste Schicht bildet die dem Leistungshalbleiterbauelement (10) zugewandte Fläche des Verbindungseinrichtung (20). Weiterhin weist die Verbindungseinrichtung (20) zwei Abschnitte der isolierenden Schicht (24) auf. Im Schichtaufbau der Verbindungseinrichtung (20) schließt sich dann auf der dem Leistungshalbleiterbauelement (10) abgewandten Seite der Verbindungseinrichtung (20) deren zweite elektrisch leitende Schicht an die ebenfalls strukturiert ist und somit drei voneinander elektrisch isolierte zweite Leiterbahnen (22) aufweist.

Mit einer dieser zweiten Leiterbahnen (26) ist ein gehauster oder auch ungehauster Sensor (50) mittels eines seiner Verbindungselemente (52) elektrisch leitend verbunden. Dieser dient der Messung beispielhaft der Strom- oder Temperaturmessung im Leistungshalbleitermodul. Zu seiner externen Verbindung weist das Leistungshalbleitermodul ein erstes internes Anschlusselement (30) auf. Diese ist als Kontaktfeder (30) mit einem ersten (32) und einem zweiten Kontaktabschnitt (36) und einem federnden Abschnitt (34) ausgebildet. Der erste Kontaktabschnitt (32) ist in elektrisch leitendem Kontakt zur zugeordneten zweiten Leiterbahn (26) und wiest hierzu eine gemeinsame Kontaktfläche (62) mit dieser auf.

Diese Kontaktfläche (62) ist in einer Ausnehmung (42) der zweite Leiterbahn (22) angeordnet, die durch eine Vertiefung derselben ausgebildet wird. Der erste Kontaktabschnitt (32) der Kontaktfeder (30) kann verschiedenartig ausgebildet sein, wesentlich ist hier allerdings die Ausbildung der Vertiefung (42) der zweiten Leiterbahn (26). Durch diese Vertiefung (42) wird eine durch mechanische oder thermische Einwirkung verursachte laterale Bewegung des ersten Kontaktabschnitts (32) der Kontaktfeder (30) weitgehend verhindert.

Eine ebensolche Wirkung wird durch die Ausnehmung (40) erzielt, die durch eine Aussparung übereinander liegende Bereiche der isolierenden Schicht (24) wie auch der zweiten elektrisch leitenden Schicht gebildet wird. Diese Aussparungen sind derart ausgebildet, dass die dadurch gebildete Ausnehmung (40) bis auf die erste elektrisch leitende Schicht durch die Verbindungseinrichtung hindurch reicht.

Die in dieser Ausnehmung (40) angeordnete Kontaktfeder (30) kontaktiert somit an der Kontaktfläche (60) diejenige erste Leiterbahn (22), die mit dem Steueranschluss (14) des Leistungshalbleiterbauelements (10) verbunden ist. Somit ist eine direkte Ansteuerung des Leistungshalbleiterbauelements (10) über das interne Anschlusselement, die Kontaktfeder (30), möglich. Hierbei ist es besonders vorteilhaft, wenn der zweite Kontaktabschnitt (36) direkt mit externen Zuleitungen verbindbar ist.

Fig. 4 zeigt ein erfindungsgemäßes Leistungshalbleitermodul im Schnitt mit einem auf einer Kühleinrichtung (76) angeordneten Substrat (74) und einem umschließenden Gehäuse (70). Die modulinterne schaltungsgerechte Verbindung ist mittels der beschrieben Verbindungseinrichtung (20) ausgebildet. Die internen Kontakteinrichtungen, die Kontaktfedern (30) von denen nur ein dargestellt ist, sind in Führungen (72) des becherförmigen Gehäuses (70) angeordnet, wobei deren zweite Kontaktabschnitte (36) aus dem Gehäuse (70) heraus ragen und direkt mit externen Anschlusselementen, wie beispielhaft einer Steuerplatine verbindbar sind.

## Patentansprüche

1. Leistungshalbleitermodul mit mindestens einem Leistungshalbleiterbauelement (10), mit einer dieses Leistungshalbleiterbauelement (10) kontaktierenden Verbindungseinrichtung (20) aus einem Schichtverbund aus mindestens einer ersten elektrisch leitenden dem Leistungshalbleiterbauelement (10) zugewandten, mindestens eine erste Leiterbahn (22) ausbildenden Schicht,
einer im Schichtverbund folgenden isolierenden Schicht (24) und einer im Schichtverbund weiter folgenden zweiten dem Leistungshalbleiterbauelement (10) abgewandten, mindestens eine zweite Leiterbahn (26)ausbildenden, Schicht,
und mit mindesten einem internen Anschlusselement (30), wobei dieses interne Anschlusselement als Kontaktfeder (30) mit einem ersten (32) und einem zweiten (36) Kontaktabschnitt und einem federnden Abschnitt (34) ausgebildet ist,
wobei der erste Kontaktabschnitt (32) eine gemeinsame Kontaktfläche (60, 62) mit einer ersten (22) oder einer zweiten Leiterbahn (26) der Verbindungseinrichtung (20) aufweist.

2. Leistungshalbleitermodul nach Anspruch 1,
wobei die Kontaktfläche (60, 62) mit einer ersten (22) oder zweiten Leiterbahn (26) in einer Ausnehmung (40, 42) der Verbindungseinrichtung (20) angeordnet ist.

3. Leistungshalbleitermodul nach Anspruch 2,
wobei diese Ausnehmung (40) gebildet wird durch eine Aussparung der zweiten Leiterbahn (22) und der isolierenden Schicht (24) und die Kontaktfläche (60) somit auf der ersten Leiterbahn (22) angeordnet ist.

4. Leistungshalbleitermodul nach Anspruch 2,
wobei diese Ausnehmung (42) gebildet wird durch ein Vertiefung der zweiten Leiterbahn (26) und die Kontaktfläche (62) somit auf der zweiten Leiterbahn (26) angeordnet ist.

5. Leistungshalbleitermodul nach Anspruch 1,
wobei die Schichtdicken der elektrisch leitenden Schichten (22, 26) zwischen 10µm und 500µm betragen und die Schichtdicke der isolierenden Schicht (24) zwischen 2µm und 100µm beträgt.

6. Leistungshalbleitermodul nach Anspruch 1,
wobei das mindestens eine Leistungshalbleiterbauelement (10) auf einem Substrat (74) angeordnet ist und das Leistungshalbleitermodul ein Gehäuse (70) aufweist, das das Substrat (74) mit dem mindestens einen Leistungshalbleiterbauelement (10) und die Verbindungseinrichtung (20) in einem Gehäuse (70) umschließt und bedeckt.

7. Leistungshalbleitermodul nach Anspruch 6,
wobei die internen Anschlusselemente (30) teilweise in Führungen (72) des Gehäuse (70) des Leistungshalbleitermoduls angeordnet sind und die zweiten Kontaktabschnitte (36) der internen Anschlusselemente (30) aus dem Gehäuse (70) herausragen und dort mit externe Anschlusselementen verbindbar sind.

8. Leistungshalbleitermodul nach Anspruch 1,
wobei mindesten eine erste Leiterbahn (22) der Verbindungseinrichtung (20) mit mindesten einem Anschlussbereich (14, 16) des Leistungshalbleiterbauelements (10) verbunden ist und diese Verbindung als stoffschlüssige Verbindung oder als Druckkontaktverbindung ausgebildet ist.
